Europäisches Patentamt

European Patent Office

Office européen des brevets

(19)

(11) Publication number: **0 206 247**
A2

(12) # EUROPEAN PATENT APPLICATION

(21) Application number: 86108329.3

(22) Date of filing: 19.06.86

(51) Int. Cl.⁴: **H 03 L 7/18**, H 03 L 7/14

(30) Priority: 21.06.85 JP 134309/85

(43) Date of publication of application: 30.12.86
Bulletin 86/52

(84) Designated Contracting States: DE FR GB NL SE

(71) Applicant: **NEC CORPORATION, 33-1, Shiba 5-chome, Minato-ku, Tokyo 108 (JP)**

(72) Inventor: **Inoue, Taketoshi NEC Corporation, 33-1, Shiba 5-chome, Minato-ku Tokyo (JP)**

(74) Representative: **Vossius & Partner, Siebertstrasse 4 P.O. Box 86 07 67, D-8000 München 86 (DE)**

(54) **PLL frequency synthesizer.**

(57) A PLL frequency synthesizer comprises a reference oscillator (1, 2), a frequency divider (8), a phase comparator (3) for phase-comparing the output of the reference oscillator (1, 2) with the output of the frequency divider (8), and first and second loop filters (5 and 13, resp.) coupled to the output of the phase comparator (3). First and second level holders (19 and 20, resp.) hold the output levels of the first and second loop filters (5 and 13, resp.) in response to first and second control signals, respectively (A and B, resp.) and first and second voltage controlled oscillators (6 and 14, resp.) vary oscillation frequencies in response to the outputs of the first and second level holders, respectively. Switch means (23) selectively supply the output signals of the first and second voltage controlled oscillators (6 and 14, resp.) to the input of the frequency divider (8) in response to a third control signal.

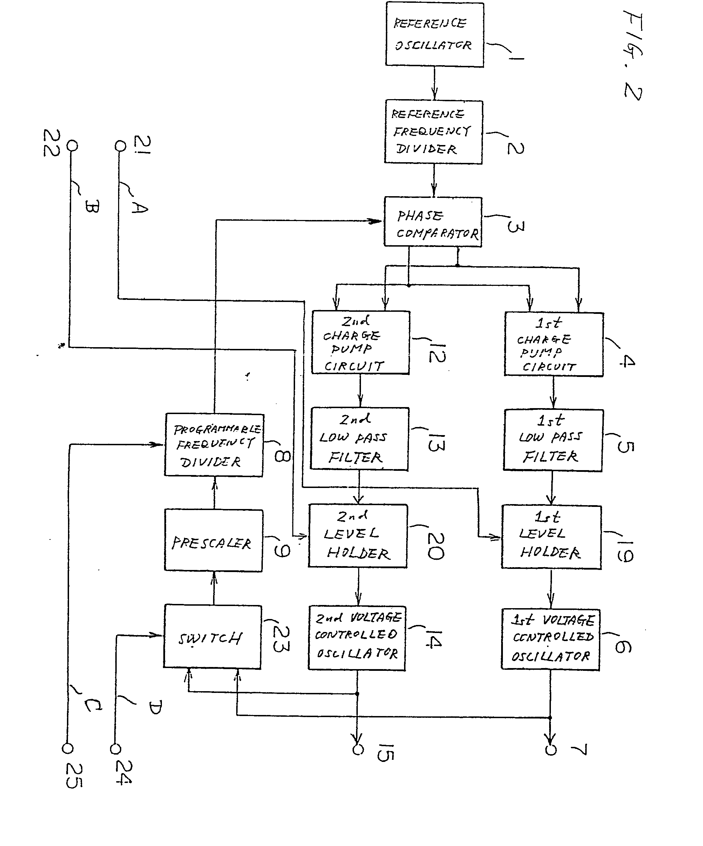

Such a transmit receive PLL frequency synthesizer has a small circuit scale and consumes a minimum of power (Fig. 2).

Our ref.: U 700 EP
Case: 134309/85
NEC Corporation
Tokyo, Japan

VOSSIUS+PARTNER
PATENTANWÄLTE
8000 MÜNCHEN 86
SIEBERTSTRASSE 4
TELEFON 474075

0206247

19. Juni 1985

## PLL FREQUENCY SYNTHESIZER

Background of the Invention

The present invention relates to a PLL (phase lock loop) frequency synthesizer and, more particularly, to a PLL frequency synthesizer for transmission and reception which is applicable to a two-way communication system, particularly a duplex communication system.

A PLL frequency synthesizer whose frequency is variable with ease is extensively used as a transmit/ receive local oscillator which is installed in a duplex transmitter/receiver and others, playing an important role in the changes and variability of channel frequencies.

Generally, a PLL frequency synthesizer comprises a reference oscillation circuit and a PLL. The reference oscillation circuit consists of a reference oscillator and a reference divider. The PLL consists at least of a phase comparator, a low pass filter (LPF), a voltage controlled oscillator (VCO), a prescaler, and a variable frequency divider.

In a duplex communication system, a PLL frequency synthesizer includes two PLLs which are assigned one to a transmitter and the other to a receiver, and a reference oscillator which is shared by the two PLLs. The problems with such a synthesizer construction are that because due

- 2 -                    0206247

to the need for two independent PLLs the scale of the
whole synthesizer is undesirably scaled up, and that
two prescalers each consuming more current than the other
constituents of the synthesizer are indispensable resulting
in considerable power consumption problem.

Summary of the Invention

It is therefore an object of the present invention
to provide a transmit/receive PLL frequency synthesizer
which has a small circuit scale and consumes a minimum
of power.

A PLL frequency synthesizer of the present invention
comprises reference oscillation circuit means; frequency
divider circuit means; phase comparator means for phase-
comparing the output of the reference oscillator means
with the output of the frequency divider circuit means;
first and second loop filter means coupled to the output
of the phase comparator means; first and second level
holder means for holding the output levels of the first
and second loop filter means in response to first and
second control signals, respectively; first and second
voltage controlled oscillator means for varying oscillation
frequencies in response to the outputs of the first and
second level holder means, respectively; and switch means
for selectively supplying the output signals of the first

0206247

and second voltage controlled oscillator means to the input of the frequency divider circuit means in response to a third control signal.

Brief Description of the Drawings

The above and other objects, features and advantages of the present invention will become more apparent from the following detailed description taken with the accompanying drawings in which:

FIG. 1 is a block diagram showing a prior art frequency synthesizer;

FIG. 2 is a block diagram showing a frequency synthesizer embodying the present invention; and

FIGS. 3A to 3D show waveforms of signals which appear respectively on lines A to D as shown in FIG. 2.

Description of the Preferred Embodiment

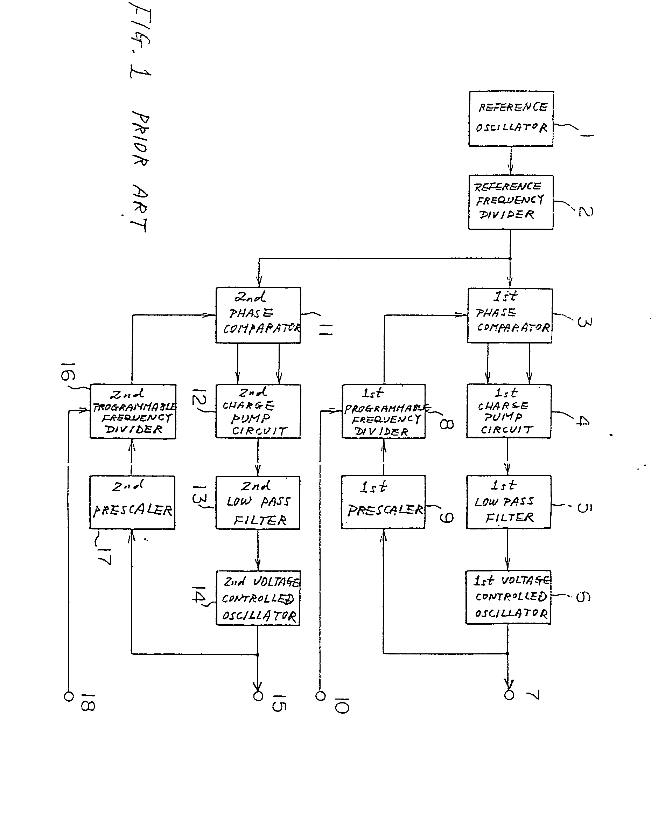

To facilitate the understanding of the present invention, reference will be made to a prior art PLL frequency synthesizer, depicted in FIG. 1. The prior art frequency synthesizer includes a reference oscillator 1 for providing a signal having a reference frequency, and a reference frequency divider 2 for frequency-dividing the output of the reference oscillator 1 to produce a first divided signal. The first divided signal is applied to a first phase comparator 3.

- 4 -

0206247

The first phase comparator 3 detects a phase difference between the first divided signal and a third divided signal which is outputted by a first programmable frequency divider 8 as will be described, thereby producing a signal representative of the phase difference. This phase difference signal is fed to a first charge pump circuit 4 the output of which is interconnected to a first low pass filter (LPF) or a first loop filter 5. A first voltage controlled oscillator (VCO) 6 to which the output of the LPF 5 is applied produces a signal whose oscillation frequency is $f_1$. Designated by the reference numeral 7 is a first output terminal. The programmable frequency divider 8 serves to divide an input frequency to a required frequency for comparison, thereby producing a third divided signal. A first prescaler 9 divides the output signal of the VCO 6 having the frequency $f_1$ to a frequency which the programmable frequency divider 8 can handle, the output of the prescaler 9 being delivered to the divider 8 as a second divided signal. The reference numeral 10 designates a first program data input terminal. A second phase comparator 11 detects a phase difference between the first divided signal from the reference frequency divider 2 and a fifth divided signal which is outputted by a second programmable frequency divider 16 as will be described. The output of the phase comparator 11 which is representative

- 5 -

0206247

of the detected phase difference is applied to a second charge pump circuit 12 the output of which is in turn applied to a second LPF or a second loop filter 13. A second VCO 14 to which a signal outputted by the LPF 13 is applied produces a signal having an oscillation frequency $f_2$. The reference numeral 15 designates a second output terminal. The programmable frequency divider 16 outputs a fifth divided signal. A second prescaler 17 divides an output of the VCO 14 having the frequency $f_2$ to a frequency which the programmable frequency divider 16 can handle, thereby producing a fourth divided signal. Designated by the reference numeral 18 is a second program data input terminal.

The reference oscillator 1 and reference frequency divider 2 constitute a reference oscillation circuit. The first phase comparator 3, first charge pump circuit 4, first LPF 5, first VCO 6, first programmable frequency divider 8 and first prescaler 9 in cooperation constitute a first PLL. The divider 8 and prescaler 9 constitute a first frequency divider circuit. Meanwhile, the second phase comparator 11, second charge pump circuit 12, second LPF 13, second VCO 14, second programmable frequency divider 16 and second prescaler 17 serve in combination as a second PLL. The divider 16 and prescaler 17 constitute a second frequency divider circuit.

The operation of the synthesizer having the above construction will be described, first that of the first PLL. As the first VCO 6 produces a signal whose local oscillation frequency is $f_1$, it is applied to the first prescaler 9. The prescaler 9 divides the input to a frequency which the first programmable frequency divider 8 can handle so as to deliver a second vidided signal. The programmable frequency divider 8 further divides the second divided signal to a required frequency for comparison, the resultant third divided signal being fed to the first phase comparator 3. Comparing the first and third divided signals, the phase comparator 3 determines a phase difference therebetween and delivers to the first charge pump 4 a phase difference signal. Supplied with an output of the charge pump circuit 4, the first LPF 5 limits the frequency band of the input and feeds an output thereof to the VCO 6. In this manner, the oscillation frequency $f_1$ of the output of the VCO 6 is controlled to a predetermined one. It will be obvious that the second PLL operates in the same manner as the first PLL. So long as the frequencies for comparison can be commonly set up, it is a common practice to use a single reference oscillator for both the first and the second PLLs.

As described above, the prior art frequency synthesizer basically requires two VCOs each oscillating with a particular frequency which is different from the other, and two independent PLLs adapted to individually control the oscillation frequencies of the VCOs to predetermined ones, resulting in a disproportionate circuit scale. Moreover, the prior art frequency synthesizer suffers from a drawback that the two prescalers each consumes current more than the other circuit elements, aggravating power consumption of the synthesizer.

Briefly, in a frequency synthesizer of the present invention, outputs of VCOs of independent PLLs are delivered to a prescaler by way of a switch which is operated time-serially. With this arrangement, the synthesizer can be implemented with only one phase comparator, only one prescaler, and only one programmable divider. The decrease in the numbers of such constituents, particularly that of prescalers, reduces power consumption and promotes small scale circuit design.

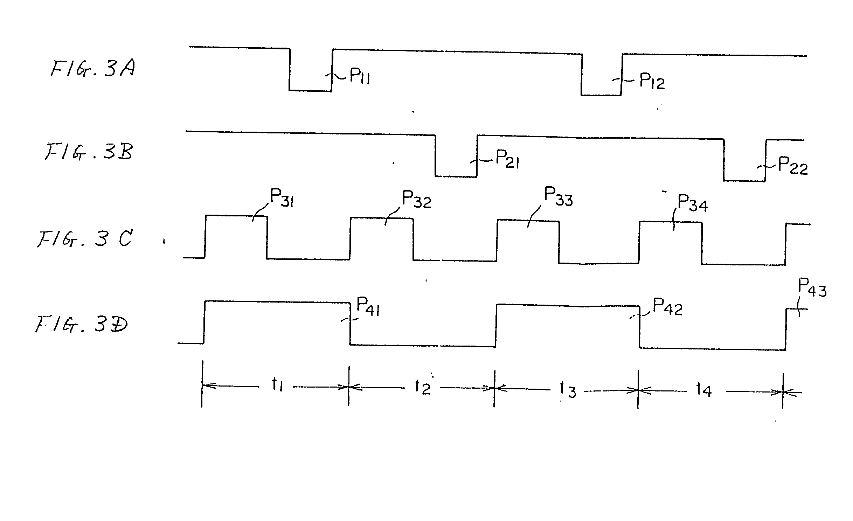

A preferred embodiment of the present invention will hereinafter be described with reference to FIGS. 2 and 3A to 3D.

Referring to FIG. 2, a frequency synthesizer in accordance with the present invention is shown. In FIG. 2, the same or similar structural elements as those shown in FIG. 1 are designated by like reference numerals. The frequency synthesizer includes a first level holder 19, a second level holder 20, a first control input terminal 21, a second control terminal 22, a switch 23, a switch control input terminal 24 and a program data input terminal 25. The input terminals 21, 22, 23 and 25 are responsive to control signals shown in FIG. 3A, 3B, 3D and 3C, respectively which are provided by a control circuit (not shown).

The reference oscillator 1 and reference frequency divider 2 constitute a reference oscillation circuit. The first phase comparator 3, first charge pump circuit 4, first LPF 5, first VCO 6, first programmable frequency divider 8, first prescaler 9, first level holder 19 and switch 23 constitute a first PLL. On the other hand, the first phase comparator 3, second charge pump circuit 12, second LPF 13, second VCO 14, first programmable frequency divider 8, first prescaler 9, second level holder 20 and switch 23 constitute a second PLL.

The frequency synthesizer constructed as shown and described will be operated as follows.

First, during a period of time $t_1$, a pulse $P_{11}$ is applied to the first control input terminal 21 as shown in FIG. 3A turning on the first level holder 19; no pulse is applied to the second control input terminal 22 as shown in FIG. 3B so that the second level holder 20 remains turned off; a program signal $P_{31}$ is applied to the program data input terminal 25 as shown in FIG. 3C setting up a predetermined frequency for comparison in the first programmable frequency divider 8, and a switch control signal $P_{41}$ is applied to the switch control input terminal 24 as shown in FIG. 3D holding the switch 23 in connection to the first VCO 6. Under this condition, as an output signal having the local oscillation frequency $f_1$ is outputted through the first output terminal 7, it is routed through the switch 23 to the first prescaler 9. In response, the prescaler 9 divides the input signal to a frequency with which the first programmable frequency divider 8 can deal, producing a second divided signal. The divider 8 further divides the second divided signal to a required frequency comparison, delivering a third divided signal to the first phase comparator 3. Then, the phase comparator 3 detects a phase difference between the first and third divided signals to deliver a signal representative of the phase difference to the first charge pump circuit 4. An error voltage generated by the charge pump circuit 4 responsive to the phase difference signal is passed through the first LPF 5 to the first level holder 19. Because the level holder 19 remains turned on so long as the pulse $P_{11}$ is applied thereto, it feeds the error voltage from the LPF 5 to the first VCO 6. In this manner, the oscillation frequency $f_1$ of a signal outputted by the VCO 6 is controlled to a predetermined one.

For the subsequent period of time $t_2$, no signal is applied to the first control input terminal 21 as shown in FIG. 3A so that the first level holder 19 remains turned off; a pulse $P_{21}$ is applied to the second control input terminal 22 as shown in FIG. 3B turning on the second level holder 20; a program signal $P_{31}$ is applied to the program data input terminal 25 as shown in FIG. 3C setting up a predetermined frequency for comparison in the first programmable divider 8, and a switch control signal is not applied to the switch control input terminal 24 so that the switch 23 is connected to the second VCO 14. In this condition, as a signal whose local oscillation frequency is $f_2$ is produced from the first output terminal 15, it is routed through the switch 23 to the first prescaler 9. The prescaler 9 divides the signal having the frequency $f_2$ to a frequency which the programmable frequency divider 8 can handle, producing a fourth divided signal. The programmable frequency divider 8 further divides the fourth divided signal to a required frequency for comparison, applying the resultant fifth divided signal to the first phase comparator 3. In response, the phase comparator 3 detects a phase difference between the first and fifth divided signals and delivers a signal representative of the phase difference to the second charge pump circuit 12. The charge pump circuit 12 generates an error voltage representative of the phase difference signal, the error voltage being applied to the second LPF 13. The output of the LPF 13 is fed to the second level holder 20. Because the level holder 20 remains turned on so long as the pulse $P_{21}$ is applied thereto, it causes the error voltage from the LPF 13 to be routed to the second VCO 14. Consequently, the oscillation frequency $f_2$ of the signal outputted by the VCO 14 is controlled to a predetermined one. In the manner described hereinabove, the first VCO 6 and the second VCO 14 may alternately be controlled in phase thereafter.

While the embodiment of the present invention has been shown and described as being furnished with two PLLs, it will be needless to mention that three or more PLLs may be configured in the frequency synthesizer, if desired.

In summary, it will be seen that a frequency synthesizer of the present invention is capable of controlling oscillation frequencies of a plurality of VCOs by use of one phase comparator, one prescaler, and one programmable frequency divider. In addition, it contributes a great deal to the reduction of power consumption and that of circuit scale.

0206247

Claims:

1.    A PLL frequency synthesizer comprising:

reference oscillation circuit means;

frequency divider circuit means;

phase comparator means for phase-comparing the output of said reference oscillator means with the output of said frequency divider circuit means;

first and second loop filter means coupled to the output of said phase comparator means;

first and second level holder means for holding the output levels of said first and second loop filter means in response to first and second control signals, respectively;

first and second voltage controlled oscillator means for varying oscillation frequencies in response to the outputs of said first and second level holder means, respectively; and

switch means for selectively supplying the output signals of said first and second voltage controlled oscillator means to the input of said frequency divider circuit means in response to a third control signal.

2.    A PLL frequency synthesizer as claimed in claim 1, wherein said reference oscillation circuit means comprises a reference oscillator and a reference frequency divider for frequency-dividing the output of said reference oscillator.

3.   A PLL frequency synthesizer as claimed in claim 1 or 2, wherein said frequency divider circuit means comprises a prescaler connected to the output of said switch means, and a programmable frequency divider responsive to a fourth control signal for frequency-dividing the output of said prescaler.

4.   A PLL frequency synthesizer as claimed in any of claims 1 to 3, further comprising first and second charge pump circuit means provided between the output of said phase comparator means, and the inputs of said first and second loop filter means, respectively.

0206247

FIG. 1 PRIOR ART

REFERENCE OSCILLATOR — 1

REFERENCE FREQUENCY DIVIDER — 2

2nd PHASE COMPARATOR — 11

1st PHASE COMPARATOR — 3

2nd PROGRAMMABLE FREQUENCY DIVIDER — 16

2nd CHARGE PUMP CIRCUIT — 12

1st PROGRAMMABLE FREQUENCY DIVIDER — 8

1st CHARGE PUMP CIRCUIT — 4

2nd PRESCALER — 17

2nd LOW PASS FILTER — 13

1st PRESCALER — 9

1st LOW PASS FILTER — 5

2nd VOLTAGE CONTROLLED OSCILLATOR — 14

1st VOLTAGE CONTROLLED OSCILLATOR — 6

18

15

10

7

FIG. 2

FIG. 3A

FIG. 3B

FIG. 3C

FIG. 3D

0206247